# DEMANDE DE BREVET EUROPEEN

(11) **EP 1 249 707 A1**
(43) Date de publication de la demande: **16.10.2002**
(21) Numéro de dépôt: 02290710.9
(22) Date de dépôt: 20.03.2002
(51) Int. Cl.: G01R 19/165, H03K 17/22

(54) **Dispositif de détection d'alimentation**

(30) Priorité: 02.04.2001 FR 0104463
(71) Demandeur: STMicroelectronics S.A., 92120 Montrouge (FR)
(72) Inventeur: Majcherczak, Sylvain, 92593 Levallois-Perret (FR); Mabboux, Guy, 92593 Levallois-Perret (FR)
(74) Mandataire: Ballot, Paul

(57) **Abrégé**

Dans un circuit intégré, un dispositif de détection 1 est prévu pour détecter une chute de tension de l'alimentation Vdd du coeur du circuit intgéré ou une montée trop lente de cette tension par rapport à une tension d'alimentation Vdd3 des circuits d'interface entrée/sortie 9 du circuit intégré, pour forcer ces circuits d'interface dans un état de haute impédance et minimiser leur consommation.

Application aux circuits intégrés basse tension

## Description

La présente invention concerne un dispositif de détection d'alimentation. Il s'applique plus particulièrement à un circuit intégré utilisant au moins deux tensions d'alimentation, une tension d'alimentation du coeur de circuit intégré, définie par la technologie de fabrication de celui-ci, et une tension d'alimentation supérieure à cette tension de coeur, liée aux interfaces externes du circuit intégré et appliquée aux circuits d'interface entrée/sortie prévus dans le circuit intégré.

De tels circuits intégrés à tension d'alimentation de coeur et tension d'alimentation d'interface distinctes sont apparus avec les nouvelles technologies de fabrication, par lesquelles on obtient des circuits intégrés basse tension. Pour ces circuits, la tension de coeur est en effet descendue à 1,8 volts dans certaines technologies (0,18µ) et à 1,2 volts dans d'autres (0,12µ).

Comme ces circuits intégrés sont amenés à être utilisés dans des systèmes dont la tension d'alimentation est plus élevée, les circuits d'interface d'entrée/sortie comprennent un étage d'adaptation de niveaux. Pour la transmission de signaux en sortie, cette adaptation de niveaux est en pratique réalisée par un commutateur de type translateur de niveau, qui reçoit la tension d'alimentation d'interface, pour assurer l'adaptation de niveau des signaux logiques reçus du coeur du circuit intégré et des circuits externes avec lesquels il échange des données.

Des signaux de contrôle interne sont habituellement utilisés pour contrôler les circuits d'interface. Certains de ces signaux traversent également des translateurs de niveaux.

Quant aux signaux reçus en entrée des circuits intégrés, ils entrent avec un niveau de tension d'interface. Leur niveau doit donc être abaissé.

Dans l'invention, on s'est aperçu qu'en pratique, ces circuits d'interface entrée-sortie étaient le siège de dysfonctionnements, liés soit à la disparition de la tension d'alimentation de coeur, soit à la montée en tension plus lente de celle-ci par rapport à la tension d'alimentation d'interface. Dans les deux situations, les translateurs de niveaux des circuits d'interface ne fonctionnent pas correctement, et on constate des dysfonctionnements du circuit intégré.

On rappelle que les translateurs de niveau ont habituellement une structure à deux branches, chacune comprenant un transistor de commande et un transistor de charge, un des transistors de commande étant commandé par un signal logique d'entrée DATA et l'autre par le signal logique inverse /DATA.

Lorsque la tension d'alimentation de coeur disparaît, les deux signaux logiques DATA et /DATA tombent à zéro. Les deux transistors de commande sont alors bloqués. La tension en sortie du translateur devient incontrôlable, dépendant des courants de fuites dans les transistors du translateur, ou de la contradiction entre deux signaux logiques.

On peut alors avoir une consommation inutile dans le circuit d'interface, liée à un fonctionnement inopiné d'une partie des circuits d'interface.

Un objet de l'invention est de détecter ces situations, pour forcer les signaux de sortie des translateurs, et par conséquent les signaux de contrôle internes et les signaux de sortie des circuits d'interface dans un état défini. Notamment, l'état le plus sûr pour les signaux de sortie en situation d'arrêt de l'alimentation de coeur, est l'état haute impédance.

Un dispositif de détection de tension répondant à ces besoins doit en outre être adapté à différentes contraintes externes.

La tension d'alimentation d'interface peut en effet avoir un niveau différent selon l'application, de 2,3 volts à 3,6 volts par exemple, pour des interfaces couvrant les tensions d'alimentation de 2,5 volts et 3,3 volts typiques.

Il faut que dans toute cette gamme de tension, le détecteur fonctionne correctement. En outre, il ne doit pas consommer dans les états stables.

Or, un détecteur classique comprend typiquement un étage inverseur commandé par la tension d'alimentation de coeur et alimenté par la tension d'alimentation d'interface au moyen d'une diode ou d'une série de diodes.

Si dans une application donnée, la tension d'alimentation d'interface est dans la limite basse, 2,3 volts dans l'exemple, on n'aura pas assez de tension pour alimenter correctement l'étage inverseur à cause de la chute de tension dans les diodes. Si dans une application donnée, la tension d'alimentation d'interface est dans la limite haute, 3,6 volts dans l'exemple, on aura au contraire trop de tension, en sorte que l'inverseur va consommer tout le temps.

Un objet de l'invention est un détecteur de tension qui répond à ces différentes contraintes.
Telle que caractérisée, l'invention concerne donc un dispositif de détection du niveau de la tension d'alimentation de coeur d'un circuit intégré par rapport au niveau d'une tension d'alimentation d'interface de niveau nominal supérieur, appliquée comme tension d'alimentation à des circuits d'interface dudit circuit intégré, pour la transmission de signaux d'entrée/sortie, ledit dispositif de détection fournissant un signal de détection appliqué aux dits circuits d'interface pour forcer leur sortie dans un état de haute impédance, et minimiser leur consommation lorsque le niveau de la tension d'alimentation de coeur est trop bas pour permettre le fonctionnement du circuit intégré.

Selon un aspect de l'invention, ce dispositif de détection de tension comprend un étage d'entrée comprenant un inverseur commandé par la tension de coeur, alimenté par la tension d'alimentation d'interface par un étage d'alimentation comprenant une diode ou série de diodes et un condensateur.

Dans une variante, le condensateur est formé par un transistor MOS de type P, connecté en série entre la diode ou série de diodes et l'inverseur de l'étage d'entrée. sa grille est alors connectée à la masse et son électrode de substrat ou caisson est connectée à la tension d'alimentation d'interface. On peut aussi prévoir de relier ensemble son drain et sa source.

Dans une autre variante de réalisation, le dispositif de détection comprend en outre un étage de sortie de type tampon, comprenant un inverseur alimenté directement par la tension d'alimentation d'interface et un transistor de tirage à ladite tension d'alimentation d'interface du noeud de sortie de l'inverseur de l'étage d'entrée, commandé par le signal délivré par ledit étage de sortie.

Dans une autre variante de réalisation, le dispositif de détection comprend une boucle de courant à gain supérieur à un associée à l'étage d'entrée et un étage de sortie connecté entre la tension d'alimentation d'interface et la masse et comprenant un premier transistor de recopie du courant de la boucle, en série avec un deuxième transistor commandé par la tension d'alimentation de coeur, le signal de détection étant fourni par le noeud intermédiaire de connexion entre lesdits premier et deuxième transistors.

Ce signal de sortie du dispositif de détection est appliqué aux circuits d'interface entrée/sortie du circuit intégré, alimentés par la tension d'alimentation d'interface Vdd3, pour les forcer dans un état de haute impédance et minimiser leur consommation.

D'autres caractéristiques et avantages de l'invention sont détaillés dans la description suivante, faite à titre indicatif et non limitatif et en référence aux dessins annexés dans lesquels :
- les figures 1 et 1bis représentent la structure de base d'un dispositif de détection d'alimentation selon l'invention;
- la figure 2 représente une première variante de réalisation d'un dispositif de détection selon l'invention;
- la figure 3 représente une deuxième variante d'un dispositif de détection selon l'invention;
- la figure 4 montre un exemple de réalisation d'un circuit d'interface entrée-sortie d'un circuit intégré à tensions d'alimentation de coeur Vdd et d'interface Vdd3;
- la figure 5 montre un exemple d'application d'un signal de détection selon l'invention à un tel circuit d'interface; et
- la figure 6 représente schématiquement un circuit intégré comprenant un tel dispositif de détection selon l'invention pour forcer le cas échéant les circuits d'interface en haute impédance et minimiser leur consommation.

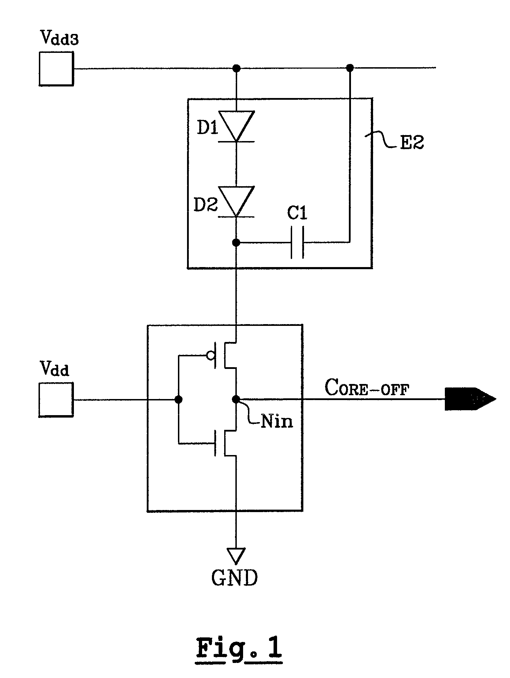

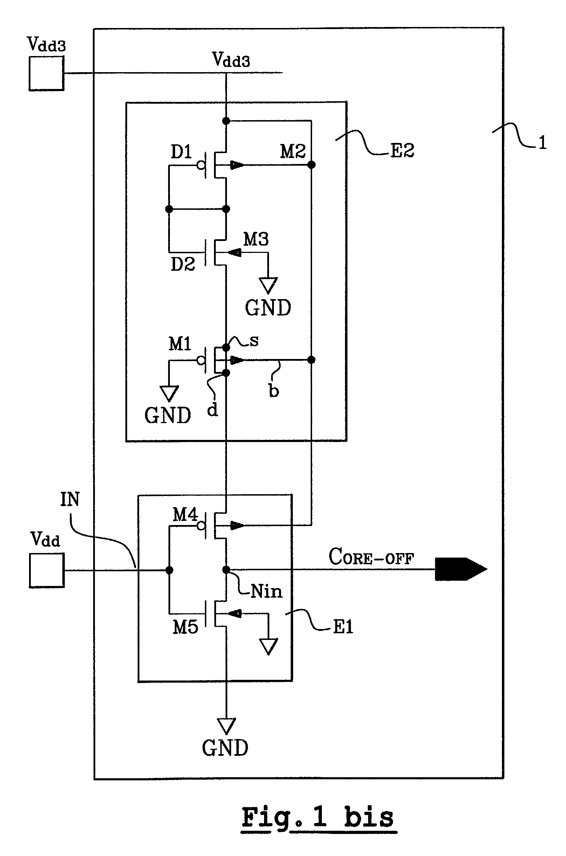

La figure 1 montre un dispositif 1 de détection d'alimentation selon l'invention. Ce circuit délivre en sortie un signal de détection C_{ORE-OFF} dont le niveau actif indique qu'une situation d'arrêt d'alimentation de coeur a été détectée. On rappelle qu'une situation d'arrêt de coeur selon l'invention résulte soit, à la mise sous tension du circuit intégré, d'une tension d'alimentation de coeur Vdd dont la montée en tension est beaucoup plus lente que celle de la tension d'alimentation d'interface Vdd3 ; soit, en cours de fonctionnement opérationnel du circuit intégré, de la disparition de la tension d'alimentation de coeur Vdd (chute de la source d'alimentation de coeur).

Un dispositif de détection selon l'invention, permet de détecter ces situations d'arrêt.

Selon l'invention, ce dispositif active un signal de détection, lorsque le niveau de la tension d'alimentation de coeur est trop bas pour permettre le fonctionnement du circuit intégré.

Un exemple de réalisation d'un tel dispositif selon l'invention est représenté sur la figure 1. Il comprend un étage d'entrée E1 comprenant un inverseur commandé en entrée IN par la tension d'alimentation de coeur.

L'inverseur de l'étage d'entrée est typiquement un inverseur CMOS qui comprend dans l'exemple un transistor MOS P M4 et un transistor MOS N M5.

Cet étage d'entrée est alimenté par la tension d'alimentation d'interface Vdd3, par un étage d'alimentation E2 comprenant une diode ou une série de diodes (dans l'exemple, deux diodes D1 et D2), et un condensateur C1.

Comme représenté sur la figure 1bis, les diodes peuvent être réalisées par des transistors MOS dont la grille et le drain sont court-circuités. Dans l'exemple, la première diode, D1, connectée à la tension d'alimentation d'interface, est formée par un transistor MOS P, M2, et la deuxième diode D2, connectée entre la première diode et le condensateur C1, est formée par un transistor MOS N, M3. Le condensateur C1 (figure 1) a l'une de ses bornes reliée à la tension d'alimentation d'interface Vdd3, l'autre borne étant connectée au point de connexion entre la diode D2 et l'entré de l'inverseur E1.

C'est le condensateur C1 qui va permettre de favoriser le basculement de l'inverseur de l'étage d'entrée, pour des tensions d'alimentation d'interface peu élevées, par exemple 2,3 volts.

En effet, les transistors M2 et M3 montés en diodes sont dimensionnés de telle sorte que le courant qui les traverse en fonctionnement normal reste faible par rapport à la consommation du reste du circuit intégré, quelles que soient les conditions de température et de tension d'alimentation d'interface. Avec un tel réglage, dans les situations d'arrêt et à faible tension d'alimentation d'interface, le courant qui traverse les transistors M2 et M3 est aussi très faible, de l'ordre de seulement quelques dizaines de pico-ampères (10⁻¹² ampères). Ce courant est trop faible pour alimenter l'inverseur E1 et faire monter sa tension en sortie.

Le condensateur C1 permet de pallier à ce problème de détection à faible tension d'alimentation d'interface.

En effet, en fonctionnement normal, le faible courant qui traverse les transistors M2 et M3 est stocké sous forme de charges électriques dans le condensateur. Si la tension d'alimentation de coeur chute, le transistor M4 devient conducteur, et le condensateur C1 se décharge à travers ce transistor M4 vers la sortie de l'inverseur E1 et fait monter la tension en sortie de l'inverseur.

Dans l'autre situation d'arrêt, lorsque la tension d'alimentation d'interface augmente plus vite que la tension d'alimentation de coeur, le condensateur C1 crée un couplage capacitif entre la tension d'alimentation d'interface et la source du transistor M4, permettant de mettre le transistor M4 dans un état conducteur et de transmettre des charges à travers ce transistor M4 vers la sortie de l'inverseur.

Sur la figure 1bis, est représenté un mode de réalisation préféré du condensateur C1. Dans ce mode de réalisation, le condensateur C1 est formé par un transistor MOS de type P, M1, dont la grille est reliée à la masse. Les drain et source de ce transistor sont reliés entre eux, au point de connexion entre la diode D2 (ou série de diodes, D1, D2) et l'inverseur de l'étage d'entrée E1.

L'électrode de substrat (ou de caisson) de ce transistor M1 est reliée à la tension d'alimentation d'interface Vdd3. Une variante non représentée peut être obtenue en retirant la liaison drain-source du transistor M1. En effet, la grille de ce transistor étant polarisé à la masse, les électrodes de drain et de source sont déjà reliées entre elles par le transistor lui-même, puisqu'il est conducteur. Dans ce cas, la source du transistor M1 est reliée à la diode D2 (ou série de diodes) et le drain du transistor M1 est relié au transistor M4 de l'inverseur de l'étage d'entrée E1.

Dans un condensateur C1 réalisé par un tel transistor M1, ce sont les capacités parasites source-substrat et drain-substrat qui sont exploitées.

Cette réalisation par un transistor-condensateur M1 est avantageuse, car elle permet de bénéficier des courants inverses de diodes source-substrat et drain-substrat de ce transistor, qui viennent s'ajouter au courant qui traverse la série de diodes D1, D2 (transistors M2, M3), favorisant ainsi la charge de ce transistor-condensateur M1.

On notera que le condensateur C1 peut être réalisé avec un transistor MOS de type N monté en condensateur de façon classique et dont la grille serait connectée à la tension d'alimentation d'interface Vdd3 et l'électrode de substrat ou caisson, le drain et la source seraient connectées ensemble au point de connexion entre la diode D2 et l'inverseur de l'étag d'entrée E1. Mais dans ce cas, on ne bénéficie pas des courants inverses de diodes.

Un tel dispositif de détection permet donc de détecter de façon efficace les situations d'arrêt dans lesquelles les signaux logiques du coeur du circuit intégré n'ont plus ou pas de signification.

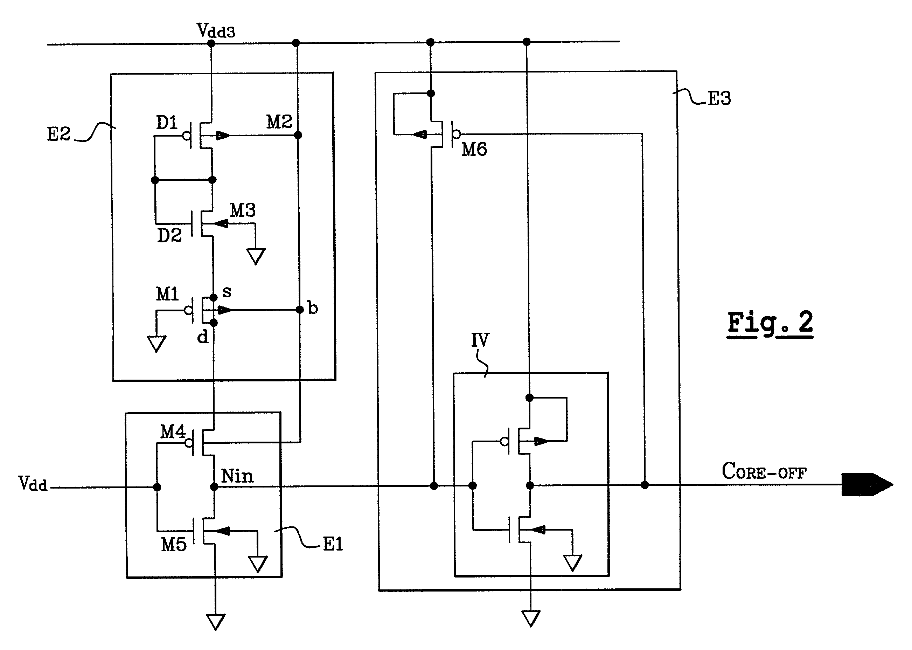

La figure 2 montre une variante de réalisation d'un dispositif de détection selon l'invention.

Avec le dispositif de détection représenté sur la figure 1, on obtient un signal de détection C_{ORE-OFF} en sortie Nin de l'inverseur dont les deux niveaux correspondants aux états logiques "0" et "1" sont 0 et Vdd3-2Vt ; où Vt représente une tension de seuil de transistor MOS.

Or ce signal de détection doit être appliqué à des circuits d'interface alimentés par la tension d'alimentation d'interface Vdd3. Notamment, si on veut bloquer un transistor MOS de type P de façon sûre, il faut lui appliquer tout le niveau de la tension d'alimentation Vdd3 sur sa grille. Le niveau de tension correspondant à l'état logique "1" fournit par le dispositif de détection décrit en relation avec la figure 1 ne remplit pas cette condition.

Le dispositif de détection représenté sur la figure 2, comprend ainsi un étage de sortie E3 à la suite de l'étage d'entrée E1, pour obtenir les niveaux désirés en sortie pour le signal de détection inverse C_{ORE-OFF}n. Cet étage de sortie E3 comprend un inverseur IV alimenté directement par la tension d'alimentation d'interface Vdd3 et un transistor M6 de tirage à la tension d'alimentation d'interface Vdd3, du noeud de sortie Nin de l'inverseur de l'étage d'entrée. Ce transistor de tirage M6 est typiquement un transistor MOS de type P, commandé sur sa grille par le signal de détection inverse C_{ORE-OFF}n fourni par l'inverseur IV de l'étage de sortie E3.

Ce transistor de tirage positif M6 permet de bien stabiliser le dispositif de détection. En effet, il permet de maintenir le noeud Nin à Vdd3, par contre-réaction.

Avec l'étage de sortie E3, on obtient une détection à hystérésis, avec un seuil bas de basculement depuis un état de présence d'alimentation de coeur vers un état d'absence d'alimentation de coeur et un seuil haut de basculement du circuit de détection depuis un état d'absence d'alimentation de coeur vers un état de présence d'alimentation de coeur. En particulier, si le noeud de sortie Nin de l'étage d'entrée est à Vdd3, il faut que le signal IN appliqué sur son entrée monte suffisamment haut pour arriver à forcer le noeud de sortie Nin vers le bas et par suite, couper le transistor de tirage M6.

Dans un exemple pratique, pour des circuits intégrés en technologie 0,18µ à tension d'alimentation de coeur de 1.8 volts, le seuil haut peut être ainsi de 0.98 volts et le seuil bas de 0.33 volts.

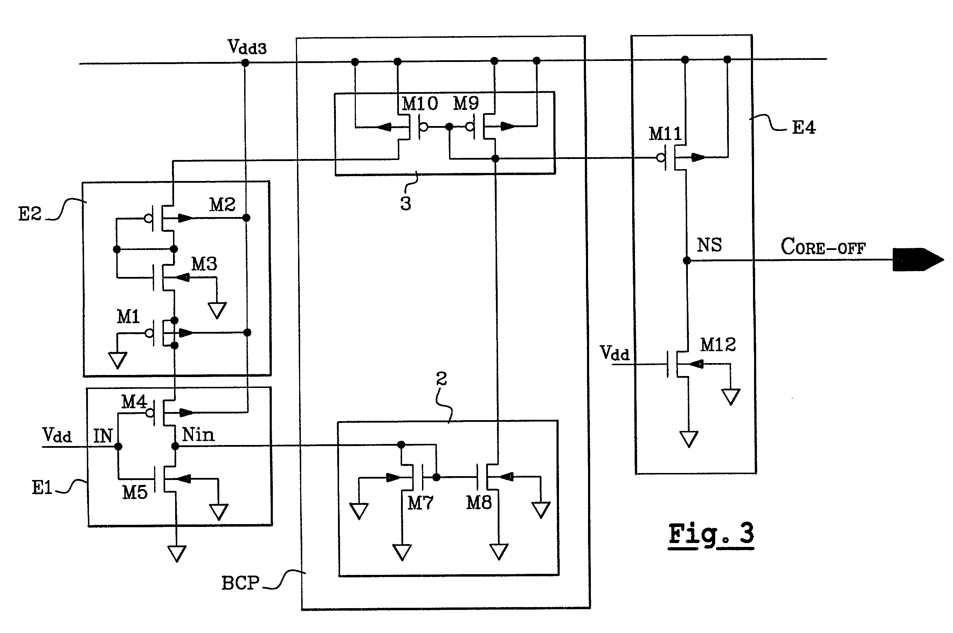

La figure 3 représente une autre variante de réalisation d'un dispositif de détection selon l'invention. Cette variante permet non seulement de fournir les niveaux de tension désirés en sortie, soit 0 et Vdd3 en pratique, mais aussi d'offrir un fonctionnement satisfaisant du dispositif de détection, alors que la différence entre les tensions d'alimentation d'interface minimale et maximale est supérieure au niveau nominal de la tension d'alimentation de coeur Vdd lui-même.

C'est ce qui se produit notamment avec des circuits intégrés en technologie 0,12µ, avec une tension d'alimentation de coeur pouvant s'abaisser jusqu'à 0,9 volts, dans des applications nécessitant une large plage de fonctionnement par rapport à la tension d'alimentation d'interface, 2,3 volts à 3,6 volts par exemple. Dans ce cas la détection de la situation d'arrêt ne peut pas reposer sur une détection d'augmentation de la différence entre la tension d'alimentation de coeur et la tension d'alimentation d'interface, puisque cette différence de tension peut être plus grande dans certains cas de fonctionnement normal que dans des situations d'arrêt.

Dans cette variante, le circuit de détection comprend en plus de l'étage d'entrée E1 et son étage d'alimentation E2, une boucle de courant BCP à gain supérieur à un 1 associée à l'étage d'entrée et un étage de sortie E4 comprenant un transistor M11 de recopie du courant dans la boucle, connecté à la tension d'alimentation d'interface et un transistor M12 directement commandé par la tension d'alimentation de coeur, et connecté à la masse.

Dans l'exemple de réalisation pratique représenté sur la figure 3, la boucle de courant associée à l'étage d'entrée comprend deux structures 2 et 3 à miroirs de courant. La première structure 2 à miroir de courant comprend un transistor MOS M7 monté en diode (grille et drain reliés), et connecté entre le noeud Nin de sortie de l'étage d'entrée E1 et la masse, et un deuxième transistor MOS M8, ayant sa grille reliée à la grille du transistor M7, soit donc au noeud Nin.

La deuxième structure 3 à miroir de courant comprend un premier transistor MOS M9 connecté en diode (grille et drain reliés) et un deuxième transistor MOS M10, connecté entre la tension d'alimentation d'interface Vdd3 et l'étage d'alimentation E2. Le transistor M9 est connecté en série avec le transistor M8, entre la tension d'alimentation d'interface Vdd3 et la masse. Le transistor M9 a sa grille reliée à celle du deuxième transistor M10. Les tailles des transistors des structures 2 et 3 de la boucle sont en pratique déterminées en sorte d'avoir un gain supérieur à 1, selon les méthodes habituelles.

L'étage de sortie E4 comprend lui les transistors M11 et M12 connectés en série entre la tension d'alimentation d'interface Vdd3 et la masse. Le premier transistor MOS M11 est connecté entre la tension d'alimentation d'interface Vdd3 et le noeud Ns de sortie qui fournit le signal de détection C_{ORE-OFF}. Il a sa grille commandée par la grille du transistor M9 avec lequel il forme un miroir de courant. Ainsi, le courant de la boucle est recopié par le transistor M11. Le deuxième transistor MOS M12 est connecté entre le noeud Ns et la masse. Il a sa grille commandée par la tension d'alimentation de coeur Vdd.

Avec un tel dispositif de détection, si la tension d'alimentation de coeur est à sa valeur nominale, 1,2 volts dans l'exemple, le transistor M5 de l'étage d'entrée E1 est passant et le noeud de sortie Nin est tiré à la masse. Il ne passe alors aucun courant dans la boucle BCP. Par ailleurs, le transistor M12 de l'étage de sortie E4 est conducteur et tire le noeud Ns de l'étage à la masse. Le courant dans les étages E1 et E2 est alors coupé par le transistor M10.

Si la tension d'alimentation de coeur Vdd chute à zéro, les transistors M5 et M12 sont bloqués. La boucle de courant est active et le transistor M11 de l'étage de sortie E4 recopie le courant de boucle. Le noeud NS (CORE-OFF) est tiré à la tension d'alimentation d'interface Vdd3.

Avec un tel dispositif de détection, la détection est effective même pour des valeurs nominales de tension d'alimentation de coeur très faibles devant la tension d'alimentation d'interface. En outre, lorsque les tensions d'alimentation sont à leurs valeurs nominales, ce dispositif n'est le siège d'aucune consommation (boucle de courant bloquée), ce qui est avantageux.

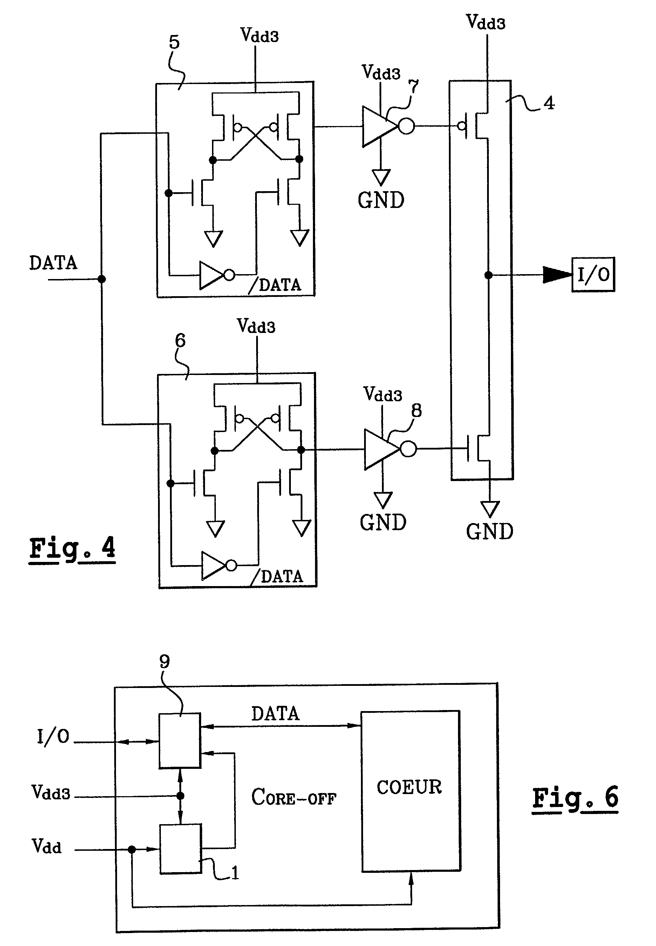

Sur la figure 4, on a représenté un exemple de circuit d'interface pour la transmission d'une donnée en sortie, auquel peut s'appliquer un signal de détection selon l'invention.

Ce circuit d'interface comprend un étage de sortie 4 de type tampon (buffer). Un tel étage de sortie est généralement à transistors N et P. Il est connecté entre la tension d'alimentation d'interface Vdd3 et la masse. Cet étage de sortie doit être commandé par des signaux de niveaux définis par rapport à cette tension d'interface. Aussi, un translateur de niveau est prévu, notés 5 et 6 sur la figure, pour fournir le signal de commande de chacun des transistors de l'étage de sortie, à partir d'un signal logique DATA, la donnée à transmettre, issu du coeur du circuit intégré. Chaque translateur (références 5 et 6 sur la figure) est habituellement suivi d'un inverseur (références 7 et 8 sur la figure) alimenté par la tension d'alimentation d'interface Vdd3, de façon à conserver la même polarité.

Dans un tel circuit d'interface, il est important d'empêcher la transmission en sortie du signal logique DATA dans les situations d'arrêt de la tension d'alimentation de coeur Vdd définies dans l'invention. Il faut donc forcer la sortie du circuit d'interface, c'est à dire la sortie du tampon, dans un état de haute impédance.

Il faut aussi empêcher la consommation inutile dans les translateurs traversés par des signaux de contrôle interne du circuit d'interface.

Pour cela, dans les situations d'arrêt définies dans l'invention, il suffit de forcer la sortie des translateurs du circuit d'interface dans un état approprié.

En forçant la sortie des translateurs à un état logique déterminé, indépendant du signal DATA à transmettre, et tel que les deux transistors du tampon soient forcés à l'état bloqué, on répond ainsi aux différents problèmes de contrôle des circuits d'interface.

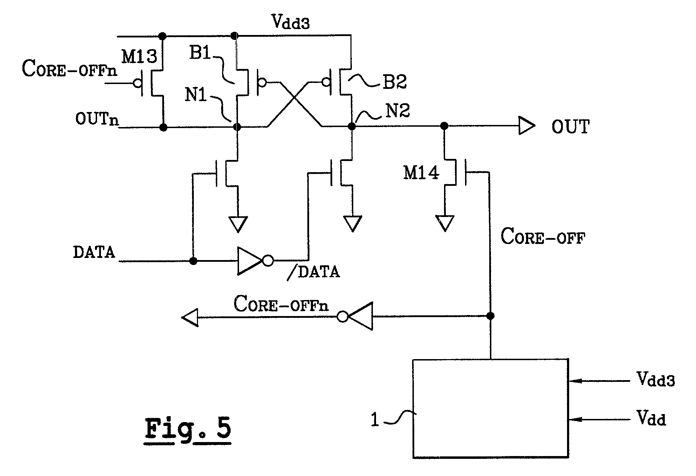

Sur la figure 5, on a représenté un translateur de niveau dans lequel on a prévu des moyens commandés par un dispositif 1 de détection selon l'invention, pour forcer, dans les situations d'arrêt, sa sortie à un état déterminé, indépendant du signal logique DATA appliqué en entrée. Ainsi, en plus de la structure habituelle à deux branches B1 et B2 du translateur, un transistor supplémentaire est prévu sur chaque branche. Un premier transistor M13 est connecté entre la tension d'alimentation d'interface Vdd3 et un noeud de sortie N1 d'une branche B1, et un deuxième transistor M14 est connecté entre le noeud de sortie de l'autre branche B2 et la masse. Dans l'exemple, le transistor M13 est un transistor MOS de type P et le transistor M14 est un transistor MOS de type N. Ces deux transistors sont commandés le premier par le signal de détection inverse C_{ORE-OFF}n et le deuxième, par le signal de détection C_{ORE-OFF}.

Lorsque le signal de détection C_{ORE-OFF} passe au niveau actif, Vdd3 dans l'exemple, le transistor M13 force le noeud de sortie N1 de la branche associée à Vdd3 tandis que le transistor M14 tire le noeud de sortie N2 de l'autre branche à zéro. Si on veut tirer les noeuds N1 et N2 à respectivement 0 et Vdd3, il suffit d'inverser les rôles des transistors M13 et M14.

Avec un dispositif de détection selon l'invention, on peut ainsi contrôler les circuits d'interface de façon sûre, en sorte que le fonctionnement des circuits intégrés dans leur environnement applicatif est fiabilisé.

Sur la figure 6, on a représenté de façon schématique un circuit intégré comprenant un dispositif de détection 1 selon l'invention, fournissant un signal de détection C_{ORE-OFF} appliqué aux circuits d'interface 9 alimentés par la tension d'alimentation d'interface Vdd3, pour les forcer, en situation d'arrêt, en haute impédance.

## Revendications

1. Dispositif de détection (1) du niveau de la tension d'alimentation de coeur (Vdd) d'un circuit intégré par rapport au niveau d'une tension d'alimentation d'interface (Vdd3) de niveau nominal supérieur, appliquée comme tension d'alimentation à des circuits d'interface dudit circuit intégré, pour la transmission de signaux d'entrée/sortie, ledit dispositif de détection fournissant un signal de détection (_{CORE-OFF}) appliqué aux dits circuits d'interface pour forcer leur sortie dans un état de haute impédance, et minimiser leur consommation lorsque le niveau de la tension d'alimentation de coeur (Vdd) est trop bas pour permettre le fonctionnement du circuit intégré, ladite détection correspondant à une situation d'arrêt de l'alimentation de coeur.

2. Dispositif de détection selon la revendication 1, **caractérisé en ce qu'**il comprend un étage d'entrée (E1) comprenant un inverseur commandé par la tension d'alimentation de coeur Vdd, ledit étage d'entrée étant alimenté par la tension d'alimentation d'interface (Vdd3) par un étage d'alimentation (E2) comprenant une diode ou une série de diodes (D1, D2) et un condensateur C1, ces diodes étant connectées en série entre ladite tension d'alimentation d'interface (Vdd3) et l'étage d'entrée (E1 et ledit condensateur (C1) ayant une électrode reliée à l'étage d'entrée (E1), l'autre électrode étant directement connectée à la tension d'alimentation d'interface (Vdd3).

3. Dispositif de détection selon la revendication 2, **caractérisé en ce que** le condensateur (C1) est formé par un transistor MOS (M1) de type P connecté en série entre la diode ou série de diodes (D1,D2) et l'inverseur de l'étage d'entrée (E1), ledit transistor ayant sa grille connectée à la masse, et son l'électrode de substrat ou caisson connectée à la tension d'alimentation d'interface (Vdd3).

4. Dispositif de détection selon la revendication 3, **caractérisé en ce que** ledit transistor MOS (M1) a sa source et son drain reliés ensemble.

5. Dispositif de détection selon l'une des revendications 2 à 4, **caractérisé en ce qu'**il comprend en outre un étage de sortie (E3) de type latch, comprenant un inverseur (IV) commandé par la sortie (Nin) de l'étage d'entrée (E1 et alimenté directement par la tension d'alimentation d'interface (Vdd3) et un transistor de tirage (M6) connecté entre ladite tension d'alimentation d'interface (Vdd3) et ladite sortie (Nin) de l'étage d'entrée, ledit transistor de tirage étant commandé par le signal (C_{ORE-OF_{R}}) délivré par ledit inverseur (IV).

6. Dispositif de détection selon l'une des revendications 2 à 4, **caractérisé en ce qu'**il comprend une boucle de courant à gain positif (BCP) associée à l'étage d'entrée (E1 et un étage de sortie (E4) comprenant un premier transistor (M11) pour recopier le courant de boucle, en série avec un deuxième transistor (M12) commandé par la tension d'alimentation de coeur (Vdd), lesdits premier et deuxième transistors étant connectés en série entre la tension d'alimentation d'interface (Vdd3) et la masse, le signal de détection (C_{ORE-OFF}) étant fourni par le noeud intermédiaire (NS) de connexion entre lesdits premier et deuxième transistors (M11, M12).

7. Circuit intégré en technologie MOS basse tension comprenant un dispositif de détection (1) selon l'une quelconque des revendications 1 à 6, pour forcer en état de haute impédance des circuits d'interface (9) d'entrée/sortie alimentés par la tension d'alimentation d'interface (Vdd3) et minimiser leur consommation dans les situations d'arrêt d'alimentation du coeur.

8. Circuit intégré selon la revendication 7, un circuit d'interface comprenant au moins un translateur (5) de niveau alimenté par la tension d'alimentation d'interface (Vdd3) et associé à un étage de sortie de données de type tampon (4), ledit translateur permettant d'adapter le niveau d'un signal logique (DATA) issu du coeur du circuit intégré, **caractérisé en ce que** ledit translateur reçoit un signal de commande (C_{ORE-OFF}) fourni par ledit dispositif de détection (1) pour forcer une sortie (OUT) dudit translateur de niveaux dans un état déterminé indépendamment du signal logique (DATA) appliqué en entrée, pour forcer l'étage de sortie associé (4) dans un état de haute impédance, dans les situations d'arrêt d'alimentation du coeur.

9. Circuit intégré selon la revendication 8, ledit translateur comprenant deux branches (B1, B2) connectées entre la tension d'alimentation d'interface (Vdd3) et la masse, chaque branche fournissant un noeud de sortie, **caractérisé en ce qu'**il comprend en outre un premier transistor (M13) connecté entre la tension d'alimentation d'interface (Vdd3) et le noeud de sortie (N1) d'une branche (B1) du translateur et un deuxième transistor connecté entre le noeud de sortie (N2) de l'autre branche (B2) du translateur et la masse, pour forcer chacun desdits noeuds dans un état déterminé.
